# EUROPÄISCHE PATENTSCHRIFT

(11) **EP 0 573 800 B1**
(45) Veröffentlichungstag und Bekanntmachung des Hinweises auf die Patenterteilung: **15.10.1997**
(21) Anmeldenummer: 93107724.2
(22) Anmeldetag: 12.05.1993
(51) Int. Cl.: G11C 7/00

(54) **Integrierte Halbleiterspeicheranordnung**
Integrated semi-conductor memory device
Dispositif intégré de mémoire à semi-conducteurs

(30) Priorität: 09.06.1992 EP 92109690
(43) Veröffentlichungstag der Anmeldung: 15.12.1993
(73) Patentinhaber: SIEMENS AKTIENGESELLSCHAFT, 80333 München (DE)
(72) Erfinder: Meyer, Willibald, 81737 München (DE); Wirth, Norbert, 85716 Unterschleissheim (DE)

(56) Entgegenhaltungen:
- EP-A- 0 135 940
- EP-A- 0 237 030
- EP-A- 0 276 870
- EP-A- 0 385 389
- EP-A- 0 487 819
- US-A- 4 855 959
- US-A- 4 858 190
- US-A- 4 882 710
- US-A- 5 093 807
- PATENT ABSTRACTS OF JAPAN vol. 012, no. 284 (P-740)4. August 1988 & JP-A-63 061 323

## Beschreibung

Die Erfindung betrifft eine integrierte Halbleiterspeicheranordnung mit einem in Zeilen und Spalten organisierten Speicherbereich, mit einem dem Speicherbereich zugeordneten Schreibzwischenspeicher zur Serien/Parallel-Konversion von einzuschreibenden Daten, dem ein Schreibzeiger und ein Eingangspuffer zugeordnet sind; mit einem dem Speicherbereich zugeordneten Lesezwischenspeicher zur Parallel/Serien-Konversion von auszulesenden Daten, dem ein Lesezeiger und ein Ausgangspuffer zugeordnet sind; und mit einer Steuereinrichtung, die mit einer Speichersteuerschaltung und mit einer Datenflußsteuerschaltung zur Steuerung des Datenflusses zwischen dem Speicherbereich und dem Schreibzwischenspeicher einerseits und dem Lesezwischenspeicher andererseits gebildet ist.

Eine solche integrierte Halbleiterspeicheranordnung ist bereits aus der US-PS 4,882,710 bekannt. Bei der dort beschriebenen Speicheranordnung werden Daten seriell mittels eines Schreibtakts in einen Eingangspuffer eingeschrieben. Von dort werden sie mittels des Schreibzeigers, der ebenfalls von dem Schreibtaktsignal getaktet wird, in den Schreibzwischenspeicher eingelesen, von dem sie parallel in einen von mehreren Teilbereichen des Speicherbereichs übergeben werden. Es wird also bei jeder Datenübergabe an einen Speicherteilbereich jeweils eine komplette Spalte dieses Teilbereichs neu beschrieben. Entsprechend dem Schreibvorgang werden beim Lesen die Daten einer kompletten Zeile eines Speicherteilbereichs in den Lesezwischenspeicher übernommen. Die Adressierung wird dabei so gestaltet, daß diejenigen Daten, die zuerst in diese Zelle eingeschrieben wurden auch zuerst wieder ausgelesen werden. Diese Speicheranordnung arbeitet somit nach dem FIFO-Prinzip. Aus dem Lesezwischenspeicher werden die Daten dann mittels dem von einem Lesetaktsignal getakteten Lesezeiger seriell in den Ausgangspuffer übergeben und aus diesem ebenfalls mittels des Lesetaktsignals aus der Speicheranordnung ausgegeben. Da diese Speicheranordnung nach dem FIFO-Prinzip arbeitet, ist sie zwar einfach aufgebaut, es ist aber kein blockweiser, wahlfreier Zugriff auf den Speicherbereich möglich, wie er beispielsweise bei Bildspeichern für das Fernsehen gewünscht wird.

Aus der EP-OS 0 135 940 ist eine integrierte Halbleiterspeicheranordnung bekannt, die einen wahlfreien Zugriff auf einzelne Speicherplätze erlaubt und zusätzlich die Möglichkeit bietet, die Daten einer kompletten Zeite in einen Zwischenspeicher zu übernehmen, aus dem die Daten dann seriell ab einer zu bestimmenden Zeilenadresse ausgelesen werden.
Diese als RAM arbeitende Speicheranordnung ermöglicht zwar blockweisen, wahlfreien Zugriff, wobei allerdings nur der Anfang eines Datenblocks durch die zu bestimmende Zeilenadresse frei wählbar ist, - das Ende des Datenblocks ist jeweils das Ende der Zeile - es ist bei dieser Speicheranordnung jedoch kein FIFO-Betrieb möglich, wie es bei sehanwendungen oftmals zweckmäßig ist.

Das der Erfindung zugrunde liegende Problem besteht darin, eine Speicheranordnung zu schaffen, die sowohl FIFO-Betrieb als auch, zumindest beim Lesen oder beim Schreiben von Daten, blockweise, wahlfreie Speicheradressierung ermöglicht.

Das Problem wird gelöst durch eine gattungsgemäße Speicheranordnung, bei der dem Lesezwischenspeicher ein den Lesezeiger steuernder Lesespaltenadressendecoder zugeordnet ist, der über eine Leseadressensteuereinheit mit einem Leseadressenregister verbunden ist, und bei der in der Speichersteuerschaltung oder im Speicherbereich ein Zeilenadressendecoder vorgesehen ist, der von der Leseadressensteuereinheit ansteuerbar ist,
und/oder bei der dem Schreibzwischenspeicher ein den Schreibzeiger steuernder Schreibspaltenadressendecoder zugeordnet ist, der über eine Schreibadressensteuereinheit mit einem Schreibadressenregister verbunden ist, und bei der der in der Speichersteuerschaltung oder dem Speicherbereich vorgesehene Zeilenadressendecoder auch von der Schreibadressensteuereinheit ansteuerbar ist.

Die Erfindung wird nachfolgend anhand eines Ausführungsbeispiels mit Hilfe von Figuren näher erläutert. Es zeigen
- Figur 1: ein Blockschaltbild einer erfindungsgemäßen tegrierten Halbleiterspeicheranordnung und
- Figur 2 bis 6: den zeitlichen Verlauf der Signale an den externen Eingängen der Speicheranordnung bei zwei unterschiedlichen, möglichen Schreib- bzw. Lesezyklen.

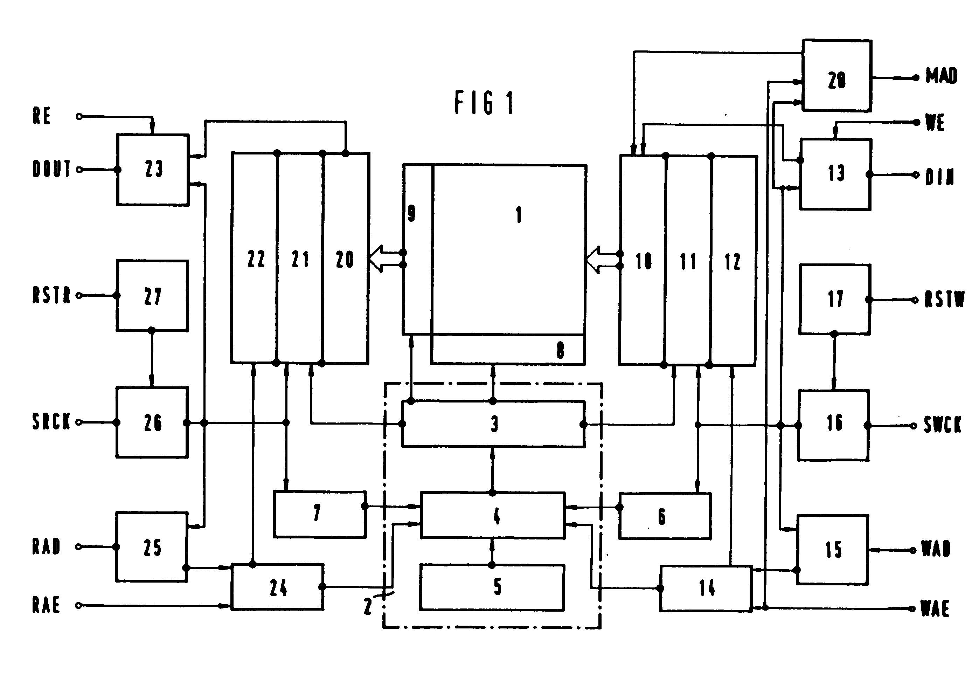

Bei der integrierten Halbleiterspeicheranordnung gemäß Figur 1 ist einem Speicherbereich 1, der in mehrere Teilbereiche unterteilt sein kann, eine Steuereinrichtung 2 zugeordnet. Diese Steuereinrichtung 2 ist mit einer Speichersteuerschaltung 3, einer Datenflußsteuerschaltung 4 sowie einem Ringoszillator 5 gebildet. Dabei steuert der Ringoszillator 5 die Datenflußsteuerungsschaltung 4 an, wenn kein externer oder ein zu langsamer externer Takt vorliegt, diese die Speichersteuerschaltung 3 und diese wiederum eine, dem Speicherbereich 1 zugeordnete Zeilendecoderschaltung 8 und ebenfalls dem Speicherbereich 1 zugeordnete Leseverstärker 9. Es ist allerdings ebenfalls möglich, die Zeilendecoderschaltung 8 in der Speichersteuerschaltung steuerschaltung 3 anzuordnen.
Eingangsseitig ist dem Speicherbereich 1 ein Schreibzwischenspeicher 10 zur Serien/Parallel-Konversion einzu-schreibender Daten, ein mit diesem verbundener Schreibzeiger 11 und ein den Schreibzeiger 11 setzender Schreibspaltenadressendecoder 12 zugeordnet.
Der Schreibzwischenspeicher 10 ist mit einem Eingangspuffer 13 verbunden, von dem er die Eingangsdaten DIN eingeschrieben bekommt. Dieser Eingangspuffer 13 dient dabei einerseits zur Pegelwandlung der Eingangsdaten DIN und andererseits zur Synchronisation der Eingangsdaten DIN mit dem Schreibtaktsignal SWCK.
Der Eingangspuffer 13 hat neben dem seriellen Eingang für die Eingangsdaten DIN, welcher jedoch mehrere Bit breit sein kann, zwei weitere Eingänge für das Schreibfreigabesignal WE und für ein Taktsignal, das er von einer Schreibtaktsteuereinheit 16 zugeführt bekommt. Diese Schreibtaktsteuereinheit 16 wird einerseits mit dem Schreibtaktsignal SWCK beaufschlagt und liefert andererseits Taktsignale an den bereits genannten Eingangspuffer 13, an einen die Datenflußsteuereinheit 4 beaufschlagenden Schreibzähler 6, an den Schreibzeiger 11 sowie an ein Schreibadressenregister 15.
Die Schreibtaktsteuereinheit 16 erhält außerdem von einer Schreibrücksetzsteuereinheit 17 ein Signal, das von einem am Eingang der Schreibrücksetzsteuereinheit 17 anliegenden Schreibrücksetzsignal RSTW abhängt.
Das Schreibadressenregister 15 ist in Figur 1 mit einem seriellen Eingang für das Schreibadressignal WAD versehen. Es kann aber ebensogut mit zwei getrennten seriellen Eingängen für ein Zeilen- und ein Spaltenadressignal oder mit parallelen Eingängen für das Schreibadressignal versehen sein. Das Schreibadressenregister 15 liefert die empfangenen Adressen an eine Schreibadressensteuereinheit 14, die ihrerseits die Spaltenadresse dem Schreibspaltenadressen12 und die Zeilenadresse der Datenflußsteuereinheit 4 zuführt, die sie ihrerseits über die Speichersteuerschaltung 3 dem im Speicherbereich 1 angeordneten Zeilendecoder 8 zuführt. Die Schreibadressensteuereinheit 14 ist außerdem mit einem Eingang versehen, an dem sie ein Schreibsteuersignal WAE erhält.

Der Schreibzwischenspeicher 10 wird von einem Maskierungsdatenregister 28 mit einem Signal beaufschlagt, so daß die im Schreibzwischenspeicher 10 abgelegten Eingangsdaten DIN entsprechend den Maskierungsdatensignal MAD maskiert werden können. Es ist aber auch möglich, die Maskierung bereits beim Einschreiben der Eingangsdaten DIN in den Schreibzwischenspeicher 10 oder bereits im Eingangspuffer 13 vorzunehmen. Das Maskierungsdatenregister 28 ist mit dem Schreibtaktsignal SWCK und mit dem Schreibsteuersignal WAE beaufschlagt, mit denen das Einlesen des Maskierungsdatensignals MAD gesteuert wird.

In äquivalenter Weise ist dem Speicherbereich 1 ausgangsseitig ein Lesezwischenspeicher 20 zur Parallel/Serien-Konversion auszulesender Daten zugeordnet. Mit dem zwischenspeicher 20 ist ein Lesezeiger 21 verbunden, der von einem Lesespaltenadressendecoder 22 gesetzt wird. Der Lesezeiger 21 wird ebenso wie ein die Datenflußsteuerschaltung 4 ansteuernder Lesezähler 7, ein Ausgangspuffer 23 und ein Leseadressenregister 25 von einem Taktsignal, das von einer Lesetaktsteuereinheit 26 stammt, versorgt. Dieses Taktsignal hängt dabei von einem am Eingang der Lesetaktsteuereinheit 26 anliegenden Lesetaktsignal SRCK ab. Die Lesetaktsteuereinheit 26 hat außerdem einen Eingang für ein Signal, das von einer Leserücksetzsteuereinheit 27 stammt und abhängig ist von einem an deren Eingang anliegenden Leserücksetzsignal RSTR.

Das Leseadressenregister 25 empfängt an seinem seriellen Eingang das Leseadressensignal RAD. Auch dieses Leseadressenregister 25 kann alternativ zwei getrennte serielle Eingänge für das Zeilen- und das Spaltenadressensignal oder parallele Eingänge für das Leseadressensignal RAD aufweisen.
Vom Leseadressenregister 25 wird die Leseadresse RAD an eine Leseadressensteuereinheit 24 gegeben, die die Spaltenadresse dem Lesespaltenadressendecoder 22 und die Zeilenadresse ebenfalls der Datenflußsteuerschaltung 4 zuführt. Die Leseadressensteuereinheit 24 wird außerdem mit einem Lesesteuersignal RAE beaufschlagt. Die von dem Speicherbereich 1 über die Leseverstärker 9 parallel in den Lesezwischenspeicher 20 übertragenen Daten werden seriell über einen Ausgangspuffer 23 in Abhängigkeit von einem Lesefreigabesignal RE als Ausgangsdaten DOUT aus der Speicheranordnung ausgelesen.

Die erfindungsgemäße Speicheranordnung läßt sich sowohl im FIFO-Modus als auch in einem Modus mit wahlfreier Blockadresse abhängig vom Zustand des Schreibsteuersignals WAE zu einem bestimmten Zeitpunkt oder während eines bestimmten Zeitbereichs beim Schreiben von Eingangsdaten DIN und vom Zustand des Lesesteuersignals RAE zu einem bestimmten Zeitpunkt oder während eines bestimmten Zeitbereichs beim Lesen von Ausgangsdaten DOUT betreiben.
Im Falle des FIFO-Modus werden die Zeilenadressen jeweils vom Schreibzähler 6 bzw. vom Lesezähler 7 generiert, während der Schreibzeiger 11 und der Lesezeiger 21 jeweils mittels des Schreibrücksetzsignals RSTW bzw. mittels des Leserücksetzsignals RSTR auf einen fest eingestellten Anfangszustand gebracht werden.
Im Modus mit wahlfreier Blockadresse liefern die Schreibadressensteuereinheit 14 und die Leseadressensteuereinheit 24 die Zeilenadresse, während der Schreibzeiger 11 bzw. der Lesezeiger 21 mittels des Schreibrücksetzsignals RSTW bzw. des Leserücksetzsignals RSTR auf den, der jeweiligen Spaltenadresse entsprechenden Anfangszustand gesetzt wird.

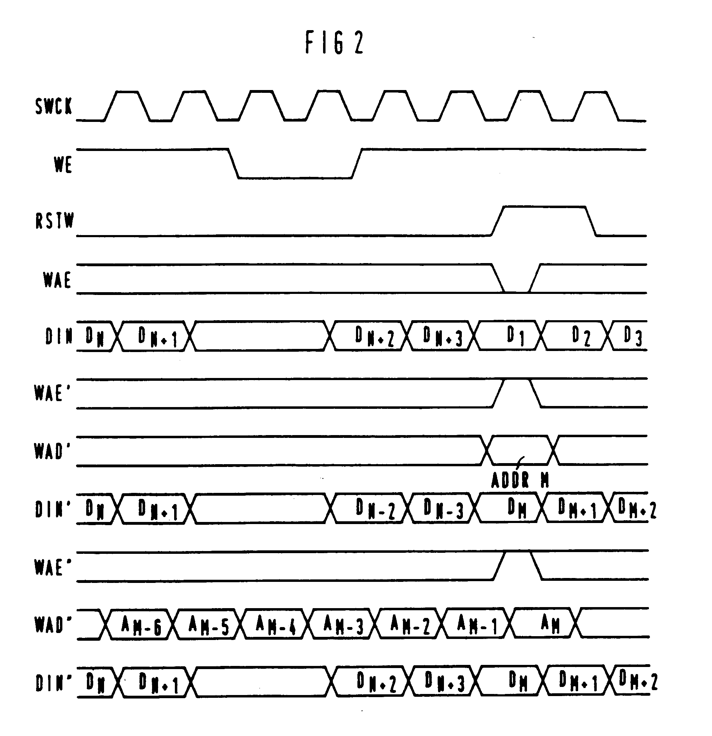

In Figur 2 ist ein erster möglicher zeitlicher Verlauf der von außen an die Speicheranordnung anzulegenden Signale für einen Schreibzyklus jeweils für den Fall des FIFO-Modus, des Modus mit wahlfreier paralleler Blockadresse und wahlfreier serieller Blockadresse dargestellt. In allen drei Fällen werden mit dem Schreibtaktsignal SWCK das Eingangsdatensignal DIN, DIN' bzw. DIN" eingeschrieben, wenn das Schreibfreigabesignal WE einen High-Zustand aufweist. Wenn das Schreibfreigabesignal WE einen Low-Zustand aufweist, werden keine Daten eingeschrieben. Der Zustand des Schreibsteuersignals WAE, WAE' bzw. WAE" zu einem Zeitpunkt, wenn das Schreibrücksetzsignal RSTW in einem High-Zustand ist bestimmt, in welchem Modus eingeschrieben wird. Beim Beispiel in Figur 2 wird bei einem Low-Zustand des Schreibsteuersignals WAE im FIFO-Modus eingeschrieben, d.h. die Daten DIN werden beginnend mit dem ersten Datum D₁ in den Schreibzwischenspeicher 10 ab der fest eingestellten Adresse eingeschrieben. Weist das Schreibsteuersignal WAE' bzw. WAE'' jedoch einen High-Zustand auf, so werden die Eingangsdaten DIN' bzw. DIN" beginnend mit dem ersten Datum D₁ ab der zu diesem Zeitpunkt gültigen parallelen Adresse ADDR M oder seriellen Adresse ...A_{M-6}...A_{M} in den Schreibzwischenspeicher 10 eingeschrieben.

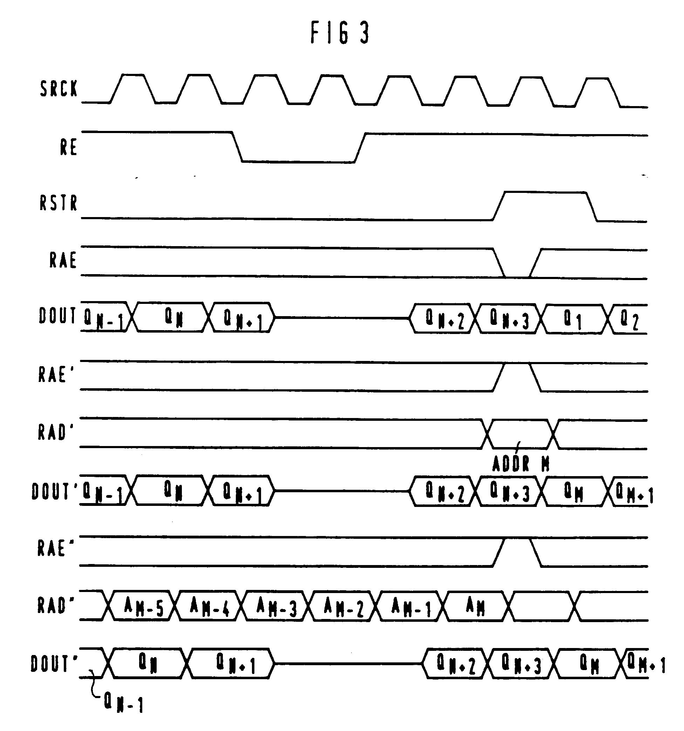

In gleicher Weise läuft ein erster möglicher Lesevorgang ab. Bei der Darstellung in Figur 3 werden Ausgangsdaten DOUT zu einem Zeitpunkt, wenn das Leserücksetzsignal RSTR einen High-Zustand, das Lesesteuersignal RAE einen Low-Zustand und das Lesefreigabesignal RE einen High-Zustand aufweist, die Daten DOUT beginnend mit dem Datum Q₁ ab der Adresse 1 aus dem Lesezwischenspeicher 20 ausgelesen.

Wenn zu diesem Zeitpunkt das Lesesteuersignal RAE', RAE" jedoch einen High-Zustand aufweist, werden die Ausgangsdaten DOUT' bwz. DOUT'' beginnend mit dem Datum Q_{M} ab der Adresse M des Lesezwischenspeichers 20 ausgelesen, wobei die Adresse M durch die parallele Adresse ADDR M oder durch die serielle Adresse ...A_{M-5}...A_{M} des Leseadressensignals RAD' bwz. RAD" bestimmt ist.
Sowohl der Lese- als auch ader Schreibvorgang können zu einem beliebigen Zeitpunkt durch ein erneutes Rücksetzsignal RSTR, RSTW abgebrochen werden.
Auf diese Weise ist ein blockweiser, wahlfreier Zugriff auf den Speicherbereich sowohl beim Schreiben als auch beim Lesen von Daten möglich. Es ist natürlich ebenso möglich, nur beim Lesen oder nur beim Schreiben von Daten einen blockweisen, wahlfreien Zugriff zu ermöglichen.

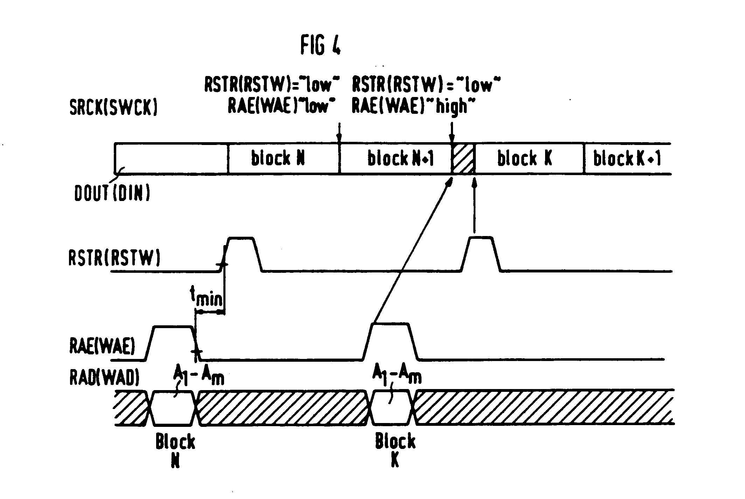

Figur 4 zeigt eine weitere, bevorzugte Möglichkeit, die erfindungsgemäße integrierte Halbleiterspeicheranordnung zu betreiben. Während des aktiven Zustands des Lesesteuersignals RAE bzw. des Schreibsteuersignals WAE - in Figur 4 ist der aktive Zustand der High-Zustand - werden die Adreßbits A₁ bis Aₙ einer Adresse, an die ein Datenblock in den Speicherbereich eingeschrieben werden soll, eingelesen. Nach einer Mindestdauer tₘᵢₙ nach dem Übergang des Lesesteuersignals RAE bzw. des Schreibsteuersignals WAE in dem inaktiven Zustand wird mit einem Leserücksetzsignal RSTR bzw. mit einem Schreibrücksetzsignal RSTW der Datenblock N, der aus den Ausgangsdaten DOUT bzw. den Eingangsdaten DIN besteht, mit Hilfe des Lesetaktsignals SRCK bzw. des Schreibtaktsignals SWCK ausgelesen bzw. eingeschrieben. Wenn, wie in Figur 4 dargestellt, bis zum Ende des Datenblocks N kein neuer aktiver Zustand des Lese- bzw. Schreibsteuersignals RAE bzw. WAE mehr aufgetreten ist, wird einerseits ein möglicherweise auftretendes Lese- bzw. Schreibrücksetzsignal RSTR bzw. RSTW ignoriert und andererseits die Speichereinrichtung im FIFO-Modus betrieben, das heißt die Adresse wird ausgehend von der zuletzt eingelesenen Adresse inkrementiert. Es wird dann also ein Datenblock N+1 aus einem Speicherbereich mit einer um 1 erhöhten Adresse ausgelesen bzw. in diesen eingeschrieben.

Wenn dann während des Auslesens bzw. Einschreibens des Datenblocks N+1 während eines aktiven Zustands die Adreßbits A₁ bis Aₘ einer neuen Adresse für einen Datenblocks K eingelesen werden, erfolgt am Ende des Auslesens bzw. schreibens des Datenblocks N+1 eine Lese- bzw. Schreibpause, sofern kein Lese- bzw. Schreibrücksetzsignal RSTR bzw. RSTW an den Halbleiterspeicher angelegt wurde. Erst mit dem Anlegen eines neuen Lese- bzw. Schreibrücksetzsignals RSTR bzw. RSTW wird dann der Datenblock K ausgelesen bzw. eingeschrieben. Da während des Auslese- bzw. Einschreibvorgangs des Datenblocks K keine neue Adresse während eines aktiven Zustands des Lese- bzw. Schreibsteuersignals RAE bzw. WAE eingelesen wird, wird nach dem Datenblock K ein Datenblock K+1 ausgelesen bzw. eingeschrieben, das heißt die Adresse wird vom internen Lese- bzw. Schreibzähler 7 bzw. 6 wieder um 1 erhöht.

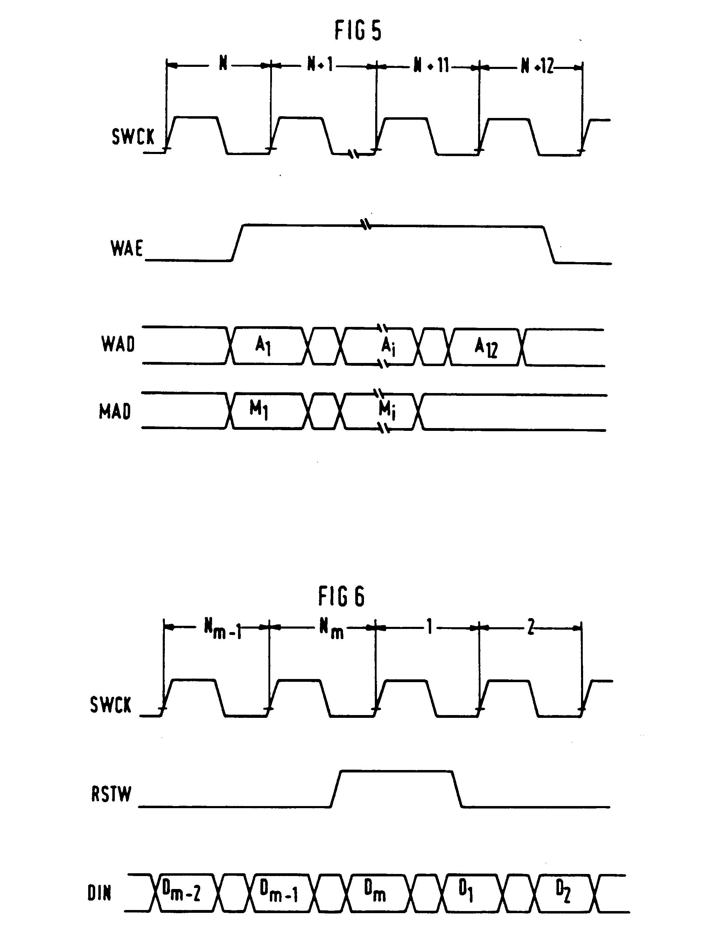

In Figur 5 ist das Einlesen einer aus 12Bit bestehenden Adresse A₁...A₂...A₁₂ detailliert am Beispiel eines Schreibadressignals WAD dargestellt. Eine Leseadresse RAD wird natürlich auf dieselbe Weise eingelesen, wobei die Länge einer Schreib- bzw. Leseadresse nicht auf 12Bit beschränkt sein muß. Der aktive Zustand des Schreibsteuersignals WAE ist im Beispiel gemäß Figur 5 der High-Zustand. Es kann aber auch der Low-Zustand sein. Nach der ansteigenden Flanke des Schreibsteuersignals WAE wird mit der nächsten darauffolgenden steigenden Flanke des Schreibtaktsignals SWCK das erste Bit A₁ des Schreibadressignals WAD eingelesen. Mit jeder weiteren steigenden Flanke des Schreibtaktsignals SWCK wird ein weiteres Bit Aᵢ des Schreibadreßsignals WAD eingelesen bis zum letzten Bit A₁₂. Danach folgt die fallende Flanke des Schreibsteuersignals WAE, die den Beginn der Mindestdauer tₘᵢₙ festlegt.

Mit dem Schreibadreßsignal WAD wird auch das Maskierungsdatensignal MAD auf dieselbe Weise wie das Schreibadreßsignal WAD eingelesen. Das Maskierungsdatensignal MAD kann dabei aus einer beliebigen Anzahl von Bits bestehen, maximal jedoch der Anzahl der Adreßsignalbits. Es kann beispielsweise nur aus 6 Bits n₁ bis n₆ bestehen, wobei jeweils 1 Bit nᵢ des Maskierungsdatensignals MAD mehrere Bits der gleichzeitig parallel eingelesenen Bits des Eingangsdatensignals DIN maskiert.

Figur 6 zeigt das Einschreiben von Eingangsdaten DIN an eine zuvor eingelesene Schreibadresse. Nach Ablauf der Mindestdauer tₘᵢₙ nach der fallenden Flanke des Schreibsteuersignals WAE wird nach dem Übergang des Schreibrücksetzsignals RSTW in den aktiven Zustand, der in Figur 6 ein High-Zustand ist, nach der darauffolgenden ansteigenden Flanke des Schreibtaktsignals SWCK das erste Datum D₁ des Eingangsdatensignals DIN in die Halbleiterspeicheranordnung eingeschrieben, wobei ein Eingangssignaldatum Dᵢ mehrere Bit breit sein kann. Mit jeder weiteren ansteigenden Flanke werden dann die restlichen Daten eines Datenblocks eingeschrieben.

## Patentansprüche

1. Integrierte Halbleiterspeicheranordnung
mit einem in Zeilen und Spalten organisierten Speicherbereich (1),
mit einem dem Speicherbereich (1) zugeordneten Schreibzwischenspeicher (10) zur Serien/Parallel-Konversion von zuschreibenden Daten, dem ein Schreibzeiger (11) und ein Eingangspuffer (13) zugeordnet sind,
mit einem dem Speicherbereich (1) zugeordneten Lesezwischenspeicher (20) zur Parallel/Serien-Konversion von zulesenden Daten, dem ein Lesezeiger (21) und ein Ausgangspuffer (23) zugeordnet sind,
und mit einer Steuereinrichtung (2), die mit einer Speichersteuerschaltung (3) und mit einer Datenflußsteuerschaltung (4) zur Steuerung des Datenflusses zwischen dem Speicherbereich (1) und dem Schreibzwischenspeicher (10) einerseits und dem Lesezwischenspeicher (20) andererseits gebildet ist,
**dadurch gekennzeichnet,**
daß dem Lesezwischenspeicher (20) ein den Lesezeiger (21) steuernder Lesespaltenadressendecoder (22) zugeordnet ist,
der über eine Leseadressensteuereinheit (24) mit einem Leseadressenregister (25) verbunden ist,
und daß in der Speichersteuerschaltung (3) oder im Speicherbereich (1) ein Zeilenadressendecoder (8) vorgesehen ist, der von der Leseadressensteuereinheit (24) ansteuerbar ist.

2. Integrierte Halbleiterspeicheranordnung
mit einem in Zeilen und Spalten organisierten Speicherbereich (1),
mit einem dem Speicherbereich (1) zugeordneten Schreibzwischenspeicher (10) zur Serien/Parallel-Konversion von zuschreibenden Daten, dem ein Schreibzeiger (11) und ein Eingangspuffer (13) zugeordnet sind,
mit einem dem Speicherbereich (1) zugeordneten Lesezwischenspeicher (20) zur Parallel/Serien-Konversion von zulesenden Daten, dem ein Lesezeiger (21) und ein gangspuffer (23) zugeordnet sind,
und mit einer Steuereinrichtung (2), die mit einer Speichersteuerschaltung (3) und mit einer Datenflußsteuerschaltung (4) zur Steuerung des Datenflusses zwischen dem Speicherbereich (1) und dem Schreibzwischenspeicher (10) einerseits und dem Lesezwischenspeicher (20) andererseits gebildet ist,
**dadurch gekennzeichnet,**
daß dem Schreibzwischenspeicher (10) ein den Schreibzeiger (11) steuernder Schreibspaltenadressendecoder (12) zugeordnet ist, der über eine Schreibadressensteuereinheit (14) mit einem Schreibadressenregister (15) verbunden ist,
und daß in der Speichersteuerschaltung (3) oder im Speicherbereich (1) ein Zeilenadressendecoder (8) vorgesehen ist, der von der Schreibadressensteuereinheit (14) ansteuerbar ist.

3. Integrierte Halbleiterspeicheranordnung nach Anspruch 1,
**dadurch gekennzeichnet,**
daß dem Schreibzwischenspeicher (10) ein den Schreibzeiger (11) steuernder Schreibspaltenadressendecoder (12) zugeordnet ist, der über eine Schreibadressensteuereinheit (14) mit einem Schreibadressenregister (15) verbunden ist, und daß der Zeilenadressendecoder (8) auch von der Schreibadressensteuereinheit (14) ansteuerbar ist.

4. Integrierte Halbleiterspeicheranordnung nach einem der Ansprüche 2 oder 3, **dadurch gekennzeichnet,** daß dem Schreibzwischenspeicher (10) ein Maskierungsdatenregister (28) zugeordnet ist, das von dem Schreibadressteuersignal (WAE) ansteuerbar ist.

5. Verfahren zum Betreiben einer der integrierten Halbleiterspeicheranordnungen nach einem der Ansprüche 1 bis 4 mit folgenden Verfahrensschritten:
- während des aktiven Zustands eines Schreib- und/oder Lesesteuersignals (WAE, RAE) werden mittels eines Schreib- und/oder Lesetaktsignals (SWCK, SRCK) die Bits (Aᵢ) eines Schreib- und/oder Leseadressignals (WAD, RAD) als Schreib- und/oder Leseadresse in das Schreib- und/oder Leseadreßregister (15, 25) eingelesen,
- frühestens nach einer Mindestdauer (tₘᵢₙ) nach dem Übergang des Schreib- und/oder Lesesteuersignals (WAE, RAE) in den inaktiven Zustand wird ein Schreib- und/oder Leserücksetzsignal (RSTW, RSTR) aktiviert,
- nach der Aktivierung des Schreib- und/oder Leserücksetzsignals (RSTW, RSTR) werden die Eingabe- und/oder Ausgabedaten (DIN, DOUT) in und/oder aus einem der zuvor eingelesenen Schreib- und/oder Leseadresse zugeordneten Speicherbereich eingeschrieben und/oder ausgelesen,
- während des Dateneinschreib- und/oder Auslesevorgangs kann das Schreib- und/oder Lesesteuersignal (WAE, RAE) erneut aktiviert werden und damit eine neue Adresse eingelesen werden,
- wenn das Schreib- und/oder Lesesteuersignal (WAE, RAE) erneut aktiviert wurde, wird durch ein nachfolgend aktiviertes Schreib- und/oder Leserücksetzsignal (RSTW, RSTR) ein erneuter Dateneinschreib- und/oder Auslesevorgang ausgelöst,
- wenn das Schreib- und/oder Lesesteuersignal (WAE, RAE) nicht aktiviert wurde, wird die zuvor eingelesene Adresse unabhängig von einem erneuten Schreib- und/oder Leserücksetzsignal (RSTW, RSTR) inkrementiert.

6. Verfahren nach Anspruch 5 zum Betreiben einer terspeicheranordnung nach Anspruch 4 mit folgendem weiteren Verfahrensschritt:
- während des aktiven Zustands des Schreibsteuersignals (WAE) wird auch ein Maskierungsdatensignal (MAD) in das Maskierungsdatenregister (28) eingelesen.

## Claims

1. Integrated semiconductor memory arrangement
having a memory area (1) organized in rows and columns, having a writing buffer memory (10), assigned to the memory area (1), for the serial/parallel conversion of data to be written in, a write pointer (11) and an input buffer (13) being assigned to the said writing buffer memory,
having a reading buffer memory (20), assigned to the memory area (1), for the parallel/serial conversion of data to be read out, a read pointer (21) and an output buffer (23) being assigned to the said reading buffer memory,
and having a control device (2), which is formed by a memory control circuit (3) and by a data flow control circuit (4) for controlling the data flow between the memory area (1) and the writing buffer memory (10), on the one hand, and the reading buffer memory (20) on the other hand,
characterized
in that the reading buffer memory (20) is assigned a reading column address decoder (22), which controls the read pointer (21) and is connected via a read address control unit (24) to a read address register (25),
and in that a row address decoder (8), which can be addressed by the read address control unit (24), is provided in the memory control circuit (3) or in the memory area (1).

2. Integrated semiconductor memory arrangement having a memory area (1) organized in rows and columns,
having a writing buffer memory (10), assigned to the memory area (1), for the serial/parallel conversion of data to be written in, a write pointer (11) and an input buffer (13) being assigned to the said writing buffer memory,
having a reading buffer memory (20), assigned to the memory area (1), for the parallel/serial conversion of data to be read out, a read pointer (21) and an output buffer (23) being assigned to the said reading buffer memory,
and having a control device (2), which is formed by a memory control circuit (3) and by a data flow control circuit (4) for controlling the data flow between the memory area (1) and the writing buffer memory (10), on the one hand, and the reading buffer memory (20) on the other hand,
characterized
in that the writing buffer memory (10) is assigned a writing column address decoder (12), which controls the write pointer (11) and is connected via a write address control unit (14) to a write address register (15),
and in that a row address decoder (8), which can be addressed by the write address control unit (14), is provided in the memory control circuit (3) or in the memory area (1).

3. Integrated semiconductor memory arrangement according to Claim 1,
characterized
in that the writing buffer memory (10) is assigned a writing column address decoder (12), which controls the write pointer (11) and is connected via a write address control unit (14) to a write address register (15), and in that the row address decoder (8) can also be addressed by the write address control unit (14).

4. Integrated semiconductor memory arrangement according to either of Claims 2 and 3, characterized in that the writing buffer memory (10) is assigned a masking data register (28), which can be triggered by the writing control signal (WAE).

5. Method for operating one of the integrated semiconductor memory arrangements according to one of Claims 1 to 4, having the following method steps:
- during the active state of a writing and/or reading control signal (WAE, RAE), the bits (Aᵢ) of a write and/or read address signal (WAD, RAD) are read as write and/or read address into the write and/or read address register (15, 25) by means of a writing and/or reading clock signal (SWCK, SRCK),
- a writing and/or reading reset signal (RSTW, RSTR) is activated no earlier than after a minimum period (tₘᵢₙ) after the transition of the writing and/or reading control signal (WAE, RAE) to the inactive state,
- after the activation of the writing and/or reading reset signal (RSTW, RSTR), the input and/or output data (DIN, DOUT) are written to and/or read from a memory area assigned to the previously read-in write and/or read address,
- during the data writing-in and/or reading-out operation, the writing and/or reading control signal (WAE, RAE) can be reactivated and thus a new address be read in,
- if the writing and/or reading control signal (WAE, RAE) has been reactivated, a renewed data writing-in and/or reading-out operation is initiated by a subsequently activated writing and/or reading reset signal (RSTW, RSTR),
- if the writing and/or reading control signal (WAE, RAE) has not been activated, the previously read-in address is incremented independently of a renewed writing and/or reading reset signal (RSTW, RSTR).

6. Method according to Claim 5 for operating a semiconductor memory arrangement according to Claim 4, having the following further method step:
- during the active state of the writing control signal (WAE), a masking data signal (MAD) is also read into the masking data register (28).

## Revendications

1. Dispositif intégré de mémoire à semi-conducteurs, comportant
une zone (1) de mémoire organisée en lignes et en colonnes,
une mémoire (10) intermédiaire d'écriture associée à la zone (1) de mémoire et destinée à une conversion série/parallèle de données à écrire, un pointeur (11) d'écriture et un tampon (13) d'entrée étant associés à la mémoire intermédiaire d'écriture
une mémoire (20) intermédiaire de lecture, qui est associée à la zone (1) de mémoire, qui est destinée à la conversion parallèle/série de données à lire et à laquelle sont associés un pointeur (21) de lecture et un tampon (23) de sortie,
un dispositif (2) de commande, qui est formé d'un circuit (3) de commande de mémoire et d'un circuit (4) de commande du flux de données entre la zone (1) de mémoire et la mémoire (10) intermédiaire d'écriture d'une part et la mémoire (20) intermédiaire de lecture d'autre part,
caractérisé en ce que
il est associé à la mémoire intermédiaire de lecture (20) un décodeur (22) d'adresse de colonnes de lecture qui commande le pointeur (21) de lecture et qui est relié par l'intermédiaire d'une unité (24) de commande d'adresse de lecture à un registre (25) d'adresse de lecture,
il est prévu dans le circuit (3) de commande de mémoire ou dans la zone (1) de mémoire un décodeur (8) d'adresse de ligne, qui peut être commandé par l'unité (24) de commande d'adresse de lecture.

2. Dispositif intégré de mémoire à semi-conducteurs, comportant
une zone (1) de mémoire organisée en lignes et en colonnes,
une mémoire (10) intermédiaire d'écriture, qui est associée à la zone (1) de mémoire, qui est destinée à la conversion série/parallèle de données à écrire et à laquelle sont associés un pointeur (11) d'écriture et un tampon (13) d'entrée,
une mémoire (20) intermédiaire de lecture, qui est associée à la zone (1) de mémoire, qui est destinée à la conversion parallèle/série de données à lire et à laquelle sont associés un pointeur (21) de lecture et un tampon (23) de sortie,
un dispositif (2) de commande, qui est formé d'un circuit (3) de commande de mémoire et d'un circuit (4) de commande du flux de données entre la zone (1) de mémoire et la mémoire (10) intermédiaire d'écriture d'une part et la mémoire intermédiaire (20) de lecture d'autre part,
caractérisé en ce que
il est associé à la mémoire intermédiaire (10) d'écriture un décodeur (12) d'adresse de colonne d'écriture, qui commande le pointeur (11) d'écriture et qui est relié par l'intermédiaire d'une unité (14) de commande d'adresse d'écriture à un registre (15) d'adresse d'écriture, et il est prévu dans le circuit (3) de commande de mémoire ou dans la zone (1) de mémoire un décodeur (8) d'adresse de ligne, qui peut être commandé par l'unité (14) de commande d'adresse d'écriture.

3. Dispositif intégré de mémoire à semi-conducteurs suivant la revendication 1,
caractérisé en ce que
il est associé à la mémoire intermédiaire (10) d'écriture un décodeur (12) d'adresse de colonnes d'écriture, qui commande le pointeur d'écriture (11) et qui est relié par l'intermédiaire d'une unité (14) de commande d'adresse d'écriture à un registre (15) d'adresse d'écriture et le décodeur (8) d'adresse de ligne peut également être commandé par l'unité (14) de commande d'adresse d'écriture.

4. Dispositif intégré de mémoire à semi-conducteurs suivant l'une des revendications 2 ou 3, caractérisé en ce qu'il est associé à la mémoire (10) intermédiaire d'écriture un registre (28) de données de masquage, qui peut être commandé par le signal (WAE) de commande d'adresse d'écriture.

5. Procédé pour faire fonctionner un des dispositifs intégrés de mémoire à semi-conducteurs suivant l'une des revendications 1 à 4, comprenant les étapes opératoires suivantes :
- on mémorise pendant l'état actif d'un signal (WAE,RAE) de commande d'écriture et/ou de lecture, au moyen d'un signal (SWCK, SRCK) de cadence d'écriture et/ou de lecture, les bits (Aᵢ) d'un signal (WAD, RAD) d'adresse d'écriture et/ou de lecture en tant qu'adresse d'écriture et/ou de lecture dans le registre (15,25) d'adresse d'écriture et/ou de lecture
- on active un signal (RSTW, RSTR) de réinitialisation d'écriture et/ou de lecture au plus tôt après une durée minimale (tₘᵢₙ) après le passage du signal (WAE, RAE) de commande d'écriture et/ou de lecture à l'état actif,
- on écrit et/ou lit, après l'activation du signal (RSTW, RSTR) de réinitialisation d'écriture et/ou de lecture les données (DIN, DOUT) d'entrée et/de sortie dans une zone de mémoire associée à l'adresse d'écriture et/ou de lecture mémorisée auparavant,
- on peut réactiver les signaux (WAE, RAE) d'écriture et/ou de lecture pendant l'opération d'écriture et/ou de lecture de données et ainsi mémoriser une nouvelle adresse,
- si l'on a réactivé le signal (WAE, RAE) de commande d'écriture et/ou de lecture, on déclenche une nouvelle opération d'écriture et/ou de lecture de données par un signal (RSTW,RSTR) de réinitialisation d'écriture et/ou de lecture activé ensuite ,
- si l'on n'a pas activé le signal (WAE, RAE) de commande d'écriture et/ou de lecture, on incrémente l'adresse mémorisée auparavant indépendamment d'un nouveau signal (RSTW, RSTR) de réinitialisation d'écriture et/ou de lecture.

6. Procédé suivant la revendication 5 pour faire fonctionner un dispositif de mémoire à semi-conducteurs suivant la revendication 4, comportant l'étape opératoire supplémentaire suivante :
- on mémorise pendant l'état actif du signal (WAE) de commande d'écriture également un signal (MAD) de données de masquage dans le registre (28) de données de masquage.
